(19) Europäisches Patentamt
European Patent Office
Office européen des brevets

(11) EP 4 678 711 A1

(12) **EUROPEAN PATENT APPLICATION**
published in accordance with Art. 153(4) EPC

(43) Date of publication:
**14.01.2026 Bulletin 2026/03**

(21) Application number: **24770808.4**

(22) Date of filing: **08.03.2024**

(51) International Patent Classification (IPC):
***C09J 183/04*** (2006.01) ***C09J 11/06*** (2006.01)
***H01L 21/304*** (2006.01)

(52) Cooperative Patent Classification (CPC):
**C09J 11/06; C09J 183/04; H01L 21/304**

(86) International application number:
**PCT/JP2024/009178**

(87) International publication number:
**WO 2024/190702 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.03.2023 JP 2023037813**

(71) Applicant: **SHIN-ETSU CHEMICAL CO., LTD.**
**Tokyo 1000005 (JP)**

(72) Inventors:
- **MUTO, Mitsuo**
  **Annaka-shi, Gunma 379-0224 (JP)**
- **SUGO, Michihiro**
  **Annaka-shi, Gunma 379-0224 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

# (54) TEMPORARY ADHESIVE FOR WAFER PROCESSING, WAFER LAMINATE, AND METHOD FOR PRODUCING THIN WAFER

(57) The present invention is a temporary adhesive for wafer processing for allowing a wafer to temporarily adhere to a support, in which the temporary adhesive for wafer processing is composed of a curable silicone resin composition that can be cured by a hydrosilylation reaction, and the curable silicone resin composition includes a phenolic antioxidant not containing a phosphorus atom or a sulfur atom. The temporary adhesive for wafer processing, having sufficient substrate holdability after wafer bonding even when a substrate with a high stepped section height is used, excellent durability to subsequent wafer processing, excellent wafer peelability after processing, in particular excellent thermal stability of wafer peelability, as well as excellent cleaning removability after peel, a wafer laminate, and a method for producing a thin wafer, are provided.

EP 4 678 711 A1

## Description

TECHNICAL FIELD

The present invention relates to: a temporary adhesive for wafer processing, a wafer laminate, and a method for producing a thin wafer.

BACKGROUND ART

Three-dimensional semiconductor packaging has become essential to achieve even higher density and capacity. The three-dimensional packaging technology is a semiconductor manufacturing technology that makes a single semiconductor chip thin and stacks it in multiple layers while connecting it with a through silicon via (TSV). In order to realize this, a process is required to make a substrate thin on which a semiconductor circuit is formed, by grinding a circuit-free surface (also called the "back surface") and further to form an electrode including a TSV on the back surface. Conventionally, in a back surface grinding process of a silicon substrate, a back surface protective tape attaches to the opposite side of a grinding surface to prevent the wafer from being damaged upon grinding. However, this tape uses an organic resin film as a supporting substrate, and although it is flexible, its strength and heat resistance are insufficient, making it unsuitable for a TSV formation process or a wiring layer formation process on a back surface.

Therefore, systems have been proposed that can withstand processes such as back surface grinding and TSV and back surface electrode formation by bonding a semiconductor substrate to a support such as silicon or glass via an adhesive layer. What is important in this case is an adhesive layer to be used when bonding the substrate to the support. This is required to be capable of bonding the substrate to the support without gaps, to be durable enough to withstand subsequent processes, and further to finally allow the thin wafer to be peeled off from the support easily. Since it is peeled at the end, this adhesive layer is also referred to as a temporary adhesive layer as used herein.

Conventionally, as publicly known temporary adhesive layers and peeling methods thereof, there are proposed a technology whereby an adhesive containing a light-absorbing substance is irradiated with high-intensity light to decompose an adhesive layer, which is then peeled off from a support (Patent Document 1), and a technology whereby a heat-meltable hydrocarbon compound is used as an adhesive and undergoes bonding and peeling processes in a heated and molten state (Patent Document 2). The former technology has problems such as being required to be equipped with an expensive apparatus such as a laser and a long time taken for processing one substrate. Moreover, the latter technique is simple because it can be controlled only by heating, whereas it can only be applied in a narrow range because it has insufficient thermal stability at elevated temperatures exceeding 200°C. Furthermore, these temporary adhesive layers are not suitable for forming of film with a uniform thickness on a substrate with a high stepped section height, and for complete adhesion to a support.

Moreover, technologies using a silicone adhesive as a temporary adhesive layer have also been proposed. This is a technology whereby a substrate is adhered to a support using a silicone adhesive of addition cure type, and when peeled off, they are immersed in a chemical that dissolves or decomposes a silicone resin, to separate the substrate from the support (Patent Document 3). Therefore, it takes an extremely long time for peel, making it difficult to apply the technology to an actual manufacturing process. Moreover, after peel, it also takes a long time to clean off a silicone adhesive remaining on the substrate as a residue, also leaving a problem in terms of cleaning removability.

To address the problems described above, there have been publicly known technologies whereby a curable silicone composition containing a non-functional polyorganosiloxane is used as a temporary adhesive layer (Patent Documents 4 and 5). With this composition, bonding a substrate and a support via a temporary adhesive layer provides adhesiveness between the substrate and the temporary adhesive layer, which can withstand substrate processing, whereas when the support is peeled off from the substrate, the temporary adhesive layer can be selectively peeled off while being adhered to the support side, as a result of which almost no temporary adhesive layer remains on the substrate after peel. This makes it possible to significantly improve the cleaning removability of the substrate after peel as well as to satisfy both the aforementioned problems of peelability and cleaning removability.

However, after bonding of the substrate and the support, when they were exposed to an elevated temperature exceeding 200°C in air for a long period of time during substrate processing before peel, silicone in the temporary adhesive layer was oxidized and deteriorated by oxygen in the air, causing a problem that the substrate and the temporary adhesive layer adhered to each other, particularly in the vicinity of the outer circumference of the bonded substrate. This could lead to an abnormality such as a temporary adhesive layer partially remaining on a substrate after peel (leaving adhesive residues) or, an abnormality such as substrate cracks upon peel in case of using a substrate made thin, thereby demanding their problems to be solved urgently.

CITATION LIST

PATENT LITERATURE

Patent Document 1: JP 2004-64040 A
Patent Document 2: JP 2006-328104 A
Patent Document 3: US 7541264 B2
Patent Document 4: WO 2021/112070 A1
Patent Document 5: WO 2021/220929 A1

SUMMARY OF INVENTION

TECHNICAL PROBLEM

The present invention has been made in view of the above-described problems, and aims to provide: a temporary adhesive for wafer processing, a wafer laminate, and a method for producing a thin wafer using the same, which lead to improved productivity of a thin wafer, such as sufficient substrate holdability after bonding even when a substrate with a high stepped section height has been used, high compatibility with a wafer back surface grinding process, a TSV formation process, and a wafer back surface wiring process, facilitation of peeling in the peeling step even after a thermal process in air at an elevated temperature for a long time after bonding, and excellent residue cleanability of a substrate after peel.

SOLUTION TO PROBLEM

In order to solve the aforementioned problems, the present invention provides a temporary adhesive for wafer processing for allowing a wafer to temporarily adhere to a support, wherein the temporary adhesive for wafer processing is composed of a curable silicone resin composition that can be cured by a hydrosilylation reaction, and the curable silicone resin composition comprises a phenolic antioxidant not comprising a phosphorus atom or a sulfur atom.
The temporary adhesive for wafer processing of the present invention, having sufficient substrate holdability after bonding even when a substrate with a high stepped section height has been used, can be highly process-compatible for a wafer back surface grinding process, a TSV formation process, and a wafer back surface wiring process. Moreover, such a temporary adhesive for wafer processing facilitates peeling in the peeling step even after a thermal process in air at an elevated temperature for a long time after bonding, has excellent residue cleanability of a substrate after peel, and the like, leading to improved productivity of a thin wafer.
Also, in the present invention, the curable silicone resin composition preferably comprises:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) a non-functional organopolysiloxane in an amount of 0.1 to 200 parts by mass,
(D) a hydrosilylation reaction catalyst in an amount of 0.1 to 5,000 ppm in terms of metal atom amount based on a total mass of components (A), (B) and (C), and
(E) the phenolic antioxidant in an amount of 1 to 100,000 ppm based on a total mass of components (A), (B) and (C).

More specifically, the curable silicone resin composition can contain these components in the temporary adhesive for wafer processing of the present invention.
In this case, the component (B) is further preferably in an amount as a mole ratio of a total of SiH groups in component (B) to a total of alkenyl groups in component (A) being from 0.3 to 5.0.
Also, the curable silicone resin composition is preferably curable by light and/or heat.
The curable silicone resin composition that is curable by light and/or heat can be more easily and more effectively cured.
Also, the phenolic antioxidant as the component (E) is preferably a hindered phenolic antioxidant.
Such a hindered phenolic antioxidant facilitates an antioxidant effect to be provided, which is preferred.
Also, it is preferable that the non-functional organopolysiloxane as the component (C) is dimethylpolysiloxane, and a 30% by mass toluene solution of the component (C) has a viscosity at 25°C of 100 to 500,000 mPa·s.
Within such a range of the viscosity, the non-functional organopolysiloxane has an appropriate molecular weight, as a result of which when the silicone resin composition is heated and cured, it does not volatize, not making it less likely to obtain the desired effect, and does not cause a wafer to crack in a wafer thermal process such as CVD, and has favorable

workability and coatability, which is preferred.

Also, the curable silicone resin composition comprising the phenolic antioxidant preferably further comprises, as component (F), a hydrosilylation reaction control agent in an amount of 0.001 to 10 parts by mass based on a total mass of the components (A), (B), and (C).

Within this range of the content of such component (F), the composition has a prolonged usable time, long-term storage stability, and favorable curability and workability of the composition.

Furthermore, the curable silicone resin composition comprising the phenolic antioxidant preferably has a 180° peel strength at 25°C after curing of 2 gf or more and 100 gf or less when a test specimen with a width of 25 mm is peeled from a silicon substrate.

Within such a range of the peel strength, there is no risk of a wafer being misaligned upon wafer grinding, facilitating peeling.

The curable silicone resin composition comprising the phenolic antioxidant also preferably has a storage modulus at 25°C after curing of 1,000 Pa or more and 1,000 MPa or less.

The curable silicone resin composition having such a storage modulus after curing has no risk of a wafer being misaligned upon wafer grinding, and it is stable upon thermal processing of a wafer.

It is also preferable that the wafer is coated with the curable silicone resin composition comprising the phenolic antioxidant to fabricate a laminate, allowing a peel interface when peeled off the laminate to be controlled so that the peel interface is an interface between a temporary adhesive layer obtained from the temporary adhesive for wafer processing and the wafer.

It is furthermore preferable that the support is coated with the curable silicone resin composition comprising the phenolic antioxidant to fabricate a laminate, allowing a peel interface when peeled off the laminate to be controlled so that the peel interface is an interface between a temporary adhesive layer obtained from the temporary adhesive for wafer processing and the support.

Also, the present invention provides: a method for producing a thin wafer, comprising the steps of:

(a) allowing a circuit-forming surface of a wafer having the circuit-forming surface on a front surface and a circuit-free surface on a back surface to peelably adhere to a support using the temporary adhesive for wafer processing according to any one of the above embodiments, to form a wafer laminate;
(b) curing the temporary adhesive;
(c) grinding or polishing the circuit-free surface of the wafer in the wafer laminate;
(d) subjecting the circuit-free surface of the wafer to processing; and
(e) peeling off the wafer subjected to the processing from the support.

Such a method for producing a thin wafer facilitates a thin wafer having a TSV structure or a bump connection structure to be produced, using the temporary adhesive layer.

Also, the present invention provides: a wafer laminate including a support, a temporary adhesive layer obtained from the temporary adhesive for wafer processing according to any one of the above embodiments, stacked on the support, and a wafer having a circuit-forming surface on a front surface and a circuit-free surface on a back surface, wherein the temporary adhesive layer is peelably adhered to the front surface of the wafer.

Such a wafer laminate stabilizes peelability between a substrate and a support and particularly facilitates the substrate to be peeled off from the support even though they have been exposed to an elevated temperature of 200°C or higher for a long period of time after bonding. Therefore, it can be applied to a wide range of semiconductor film deposition processes, also has excellent CVD (chemical vapor deposition) resistance, also can form a temporary adhesive layer with high film thickness uniformity even on wafers with stepped sections to be able to facilitate production of breakable thin wafer. Also, since the temporary adhesive can also selectively adhere to a support, no residue derived from the temporary adhesive remains on a substrate after peel, and it also has excellent cleaning removability in the subsequent process.

## ADVANTAGEOUS EFFECTS OF INVENTION

The temporary adhesive for wafer processing of the present invention can improve the heat resistance of a resin by using a curable silicone resin composition containing an antioxidant. This stabilizes peelability between a substrate and a support and particularly facilitates the substrate to be peeled off from the support even though they have been exposed to an elevated temperature of 200°C or higher for a long period of time after bonding. Therefore, it can be applied to a wide range of semiconductor film deposition processes, also has excellent CVD (chemical vapor deposition) resistance, also can form a temporary adhesive layer with high film thickness uniformity even on wafers with stepped sections to be able to facilitate production of breakable thin wafer. Also, since the temporary adhesive of the present invention can also selectively adhere to a support, no residue derived from the temporary adhesive remains on a substrate after peel, and it also has excellent cleaning removability in the subsequent process. According to the method for producing a thin wafer of

the present invention, a thin wafer having a TSV structure or a bump connection structure can be easily produced.

DESCRIPTION OF EMBODIMENTS

The present inventors have found as a result of diligent investigations to solve the aforementioned problems that the above problems can be solved by using, as a temporary adhesive, a curable silicone resin composition comprising a phenolic antioxidant not comprising a phosphorus atom or a sulfur atom and can be cured by a hydrosilylation reaction, and thus have completed the present invention.

Namely, the temporary adhesive for wafer processing of the present invention is a temporary adhesive for wafer processing for allowing a wafer to temporarily adhere to a support, wherein the temporary adhesive for wafer processing is composed of a curable silicone resin composition that can be cured by a hydrosilylation reaction, and the curable silicone resin composition comprises a phenolic antioxidant not comprising a phosphorus atom or a sulfur atom.

[Temporary adhesive for wafer processing]

As described above, the temporary adhesive for wafer processing of the present invention is composed of a curable silicone resin composition containing an antioxidant. Due to its applicability to a silicon wafer and the like having step sections, a silicone resin composition with favorable spin-coatability is suitably used as a temporary adhesive for wafer processing.

Such a curable silicone resin composition preferably contains, for example, the following components (A) to (E). Herein, the composition is curable by heat and/or light using a hydrosilylation reaction catalyst as component (D) to be used.

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) a non-functional organopolysiloxane in an amount of 0.1 to 200 parts by mass,
(D) the phenolic hydrosilylation reaction catalyst in an amount of 0.1 to 5,000 ppm in terms of metal atom amount based on a total mass of components (A), (B) and (C), and
(E) an antioxidant in an amount of 1 to 100,000 ppm based on a total mass of components (A), (B) and (C).

[Component (A)]

The component (A) is an organopolysiloxane having two or more alkenyl groups in one molecule. Examples of the component (A) include a linear or branched diorganopolysiloxane containing two or more alkenyl groups in one molecule and an organopolysiloxane having a three-dimensional network structure containing two or more alkenyl groups in one molecule and having a siloxane unit (Q unit) represented by a $SiO_{4/2}$ unit. Of these, a diorganopolysiloxane or an organopolysiloxane having a three-dimensional network structure and an alkenyl group content rate of 0.6 to 9 mol%, is preferred. It is to be noted that the alkenyl group content rate as used herein refers to the proportion of a siloxane unit containing an alkenyl group in all siloxane units.

An example of such an organopolysiloxane includes an organopolysiloxane represented by the following formula (A-1), (A-2), or (A-3). These may be used singly or in combination of two or more thereof.

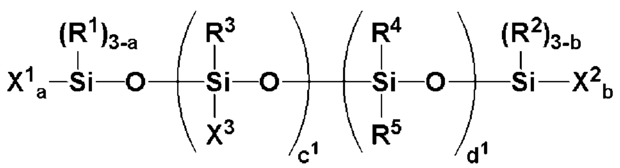

(A-1)

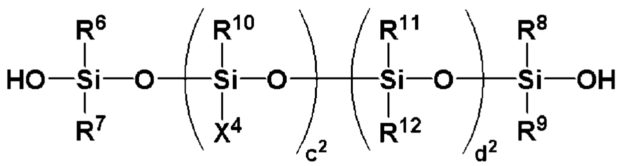

(A-2)

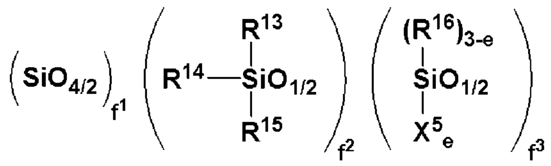

(A-3)

In formulae (A-1) to (A-3), $R^1$ to $R^{16}$ are each independently a monovalent hydrocarbon group other than an aliphatic unsaturated hydrocarbon group. $X^1$ to $X^5$ are each independently an alkenyl group-containing monovalent organic group.

In formula (A-1), a and b are each independently an integer of 0 to 3. In formulae (A-1) and (A-2), $c^1$, $c^2$, $d^1$, and $d^2$ are integers that satisfy $0 \leq c^1 \leq 10$, $2 \leq c^2 \leq 10$, $0 \leq d^1 \leq 100$, and $0 \leq d^2 \leq 100$, with the proviso that $a + b + c^1 \geq 2$. a, b, $c^1$, $c^2$, $d^1$, and $d^2$ are preferably a combination of numerals such that the alkenyl group content rate is 0.6 to 9 mol%.

In formula (A-3), e is an integer of 1 to 3. $f^1$, $f^2$, and $f^3$ are numerals such that $(f^2 + f^3)/f^1$ is 0.3 to 3.0 and $f^3/(f^1 + f^2 + f^3)$ is 0.01 to 0.6.

The monovalent hydrocarbon group other than an aliphatic unsaturated hydrocarbon group is preferably those having 1 to 10 carbon atoms, and examples thereof include alkyl groups such as a methyl group, an ethyl group, a n-propyl group, an isopropyl group, a n-butyl group, a tert-butyl group, a n-pentyl group, and an n-hexyl group; cycloalkyl groups such as a cyclopentyl group and a cyclohexyl group; and aryl groups such as a phenyl group and a tolyl group. Of these, an alkyl group such as a methyl group or a phenyl group is preferred.

The alkenyl group-containing monovalent organic group is preferably those having 2 to 10 carbon atoms, and examples thereof include alkenyl groups such as a vinyl group, an allyl group, a hexenyl group, and an octenyl group; (meth)acryloylalkyl groups such as an acryloylpropyl group, an acryloylmethyl group, and a methacryloylpropyl group; (meth)acryloxyalkyl groups such as an acryloxypropyl group, an acryloxymethyl group, a methacryloxypropyl group, and a methacryloxymethyl group; and alkenyl group-containing monovalent hydrocarbon groups such as a cyclohexenylethyl group and a vinyloxypropyl group. Among these, the vinyl group is preferred from an industrial viewpoint.

In formula (A-1), a and b are each independently an integer of 0 to 3, but when a is 1 to 3, the molecular chain end is blocked with an alkenyl group to be able to form a highly reactive alkenyl group at its molecular chain end, as a result of which the reaction can be completed in a short time, which is preferable. Also, from the viewpoint of cost, it is industrially preferable that a is 1. The properties of the alkenyl group-containing diorganopolysiloxane represented by formula (A-1) or (A-2) are preferably oily or raw rubbery.

The organopolysiloxane represented by formula (A-3) includes a $SiO_{4/2}$ unit and has a three-dimensional network structure. In formula (A-3), e is each independently an integer of 1 to 3, but from the viewpoint of cost, it is industrially preferable that e is 1. Also, a product of an average value of e and $f^3/(f^1 + f^2 + f^3)$ is preferably 0.02 to 1.5 and more preferably 0.03 to 1.0. The organopolysiloxane represented by formula (A-3) may be used as a solution dissolved in an organic solvent.

The number-average molecular weight (Mn) of the organopolysiloxane as component (A) is preferably 100 to 1,000,000, and more preferably 1,000 to 100,000. The Mn staying within the above range is preferable in terms of workability associated with the viscosity of the composition and processability associated with a storage modulus after curing. It is to be noted that the Mn as used herein is a value in terms of polystyrene, measured by gel permeation chromatography using toluene as a solvent.

Component (A) may be used singly or in combination of two or more thereof. It is particularly preferable to use a combination of the organopolysiloxane represented by formula (A-1) and the organopolysiloxane represented by formula (A-3). In this case, the amount of organopolysiloxane represented by formula (A-3) used is preferably 1 to 1,000 parts by mass and more preferably 10 to 500 parts by mass, based on 100 parts by mass of the organopolysiloxane represented by formula (A-1).

[Component (B)]

Component (B) is a crosslinking agent, and is an organohydrogenpolysiloxane having at least two, preferably three or more, silicon atom-bonded hydrogen atoms (SiH groups) in one molecule. The organohydrogenpolysiloxane may be any of linear, branched, or cyclic. The organohydrogenpolysiloxane may be used singly or in combination of two or more thereof.

The viscosity of the organohydrogenpolysiloxane as component (B) at 25°C is preferably 1 to 5,000 mPa·s and more preferably 5 to 500 mPa·s. The viscosity as used herein is a value measured at 25°C using a rotational viscometer.

The Mn of the organohydrogenpolysiloxane as component (B) is preferably 100 to 100,000 and more preferably 500 to 10,000. The Mn staying within the above range is preferable in terms of workability associated with the viscosity of the composition and processability associated with a storage modulus after curing.

Component (B) is preferably compounded so that a mole ratio (SiH group/alkenyl group) of the total of the SiH

groups in component (B) to the total of the alkenyl groups in component (A) is in the range of 0.3 to 10, more preferably in the range of 0.3 to 5.0, and still more preferably in the range of 0.5 to 3.0. The mole ratio of 0.3 or more allows a temporary adhesive layer to be sufficiently cured without a reduction in crosslink density. Also, the mole ratio of 10 or less can provide a sufficient adhesive strength and tackiness without a crosslink density being too high, and can prolong a usable time of a treating liquid.

[Component (C)]

Component (C) is a non-functional organopolysiloxane. Herein, the term "non-functional" means that component (E) has no reactive group such as a hydrogen atom, a halogen atom, a hydroxy group, or an alkoxy group, which is directly bonded to a silicon atom in the molecule, and has no reactive group such as an alkenyl group or an epoxy group, bonded to a silicon atom directly or via an arbitrary group.

An example of such a non-functional organopolysiloxane includes an organopolysiloxane having a monovalent hydrocarbon group other than an aliphatic unsaturated hydrocarbon group, which is unsubstituted or substituted and has 1 to 12 carbon atoms, preferably 1 to 10 carbon atoms. Examples of such a monovalent hydrocarbon group include alkyl groups such as a methyl group, an ethyl group, a propyl group, a butyl group, a pentyl group, a hexyl group, and a heptyl group; a cycloalkyl group such as a cyclohexyl group; aryl groups such as a phenyl group, a tolyl group, a xylyl group, and a naphthyl group; and aralkyl groups such as a benzyl group and a phenethyl group. Also, a hydrogen atom in these groups may be partially or all substituted with a halogen atom such as a chlorine atom, a fluorine atom, or a bromine atom, and examples of such groups include halogenated alkyl groups such as a chloromethyl group, a 3-chloropropyl group, and a 3,3,3-trifluoropropyl group. The monovalent hydrocarbon group is preferably an alkyl group or an aryl group and more preferably a methyl group or a phenyl group.

The molecular structure of the non-functional organopolysiloxane as component (C) is not particularly limited and may be linear, branched, cyclic, or the like, however, a linear or branched organopolysiloxane is preferred, and a linear diorganopolysiloxane in which the main chain is basically composed of a diorganosiloxane repeating unit and both ends of the molecular chain are blocked with triorganosiloxy groups is preferred.

The 30% by mass toluene solution of the non-functional organopolysiloxane as component (C) preferably has a viscosity (25°C) of 100 to 500,000 mPa·s and more preferably 200 to 100,000 mPa·s, from the viewpoint of workability of the composition, coatability to a substrate, the mechanical properties of a cured product, and peelability of a support. Within such a range of the viscosity, the non-functional organopolysiloxane has an appropriate molecular weight, as a result of which when the silicone resin composition is heated and cured, it does not volatile, making it less likely not to obtain the desired effect, and does not cause a wafer to crack in wafer thermal process such as CVD, and has favorable workability and coatability, which is preferred.

Examples of the non-functional organopolysiloxane include a dimethylsiloxane polymer blocked with trimethylsiloxy groups at both ends of the molecular chain, a phenylmethylpolysiloxane blocked with trimethylsiloxy groups at both ends of the molecular chain, a 3,3,3 trifluoropropylmethylsiloxane polymer blocked with trimethylsiloxy groups at both ends of the molecular chain, a dimethylsiloxane·methylphenylsiloxane copolymer blocked with trimethylsiloxy groups at both ends of the molecular chain, a dimethylsiloxane·3,3,3-trifluoropropylmethyl copolymer blocked with trimethylsiloxy groups at both ends of the molecular chain, a methylphenylsiloxane·3,3,3-trifluoropropylmethyl copolymer blocked with trimethylsiloxy groups at both ends of the molecular chain, a dimethylsiloxane ·3,3,3-trifluoropropylmethylsiloxane·-methylphenylsiloxane copolymer blocked with trimethylsiloxy groups at both ends of the molecular chain, a dimethylpolysiloxane blocked with dimethylphenylsiloxy groups at both ends of the molecular chain, a methylphenylpolysiloxane blocked with dimethylphenylsiloxy groups at both ends of the molecular chain, and a dimethylsiloxane·methylphenylsiloxane copolymer blocked with dimethylphenylsiloxy groups at both ends of the molecular chain.

The non-functional organopolysiloxane as component (C) may be used singly or in combination of two or more thereof. Also, the properties thereof are preferably oily or rubbery.

The component (C) is preferably compounded in an amount of 0.1 to 200 parts by mass and more preferably 1 to 100 parts by mass, based on 100 parts by mass of component (A). The compounding ratio of 0.1 parts by mass or more allows a support to be easily peeled off in the step of peeling off the support from the substrate, which is preferred. Furthermore, the compounding ratio of 200 parts by mass or less results in wafer processing durability without peeling of wafer upon wafer processing such as wafer back surface grinding and subsequent heat treatment, which is preferred.

[Component (D)]

Component (D) is a hydrosilylation reaction catalyst, preferably a platinum group-metallic hydrosilylation reaction catalyst. Component (D) is a catalyst that accelerates an addition reaction between an alkenyl group in component (A) and a hydrosilyl group in component (B), and examples thereof include a thermally activated hydrosilylation reaction catalyst (D-1) that is activated by heat and a photoactivated hydrosilylation reaction catalyst (D-2) that is

activated by light. These hydrosilylation reaction catalysts are both generally compounds of precious metals, which are expensive, and therefore platinum or a platinum compound, which is relatively available, is often used.

(D-1) Thermally activated hydrosilylation reaction catalyst

Examples of the platinum compound can include chloroplatinic acid or complexes of chloroplatinic acid with an olefin such as ethylene and with an alcohol or a vinylsiloxane, and metallic platinum supported on silica, alumina, carbon, or the like. Platinum group-metallic catalysts other than the platinum compound, which are rhodium-, ruthenium-, iridium-, and palladium-based compounds are also known, and examples thereof include $RhCl(PPh_3)_3$, $RhCl(CO)(PPh_3)_2$, $Ru_3(CO)_{12}$, $IrCl(CO)(PPh_3)_2$, and $Pd(PPh_3)_4$. It is to be noted that in the formula above, Ph is a phenyl group.

(D-2) Photoactivated hydrosilylation reaction catalyst

This photoactivated hydrosilylation reaction catalyst is activated by irradiation with light, particularly ultraviolet light with a wavelength of 300 to 400 nm, and accelerates an addition reaction between an alkenyl group in component (A) and a Si-H group in component (B). This acceleration effect depends on temperature, and the higher the temperature, the more the acceleration effect is obtained. Therefore, after irradiation of light, it is preferable to use the catalyst at an environmental temperature of 0 to 200°C and more preferably 10 to 100°C, in terms of completion of reaction within an appropriate reaction time.

A ligand of this catalyst, which exhibits catalytic activity with UV light of medium to long wavelengths from UV-B to UV-A, is preferable in terms of inhibiting a wafer from being damaged. Examples of such a ligand include a cyclic diene ligand and a β-diketonato ligand.

From those described above, preferred examples of the photoactivated hydrosilylation reaction catalyst include, as a catalyst of cyclic diene ligand type, a ($\eta^5$-cyclopentadienyl)tri(σ-alkyl)platinum(IV) complex, and in particular specific examples thereof include (methylcyclopentadienyl)trimethylplatinum(IV), (cyclopentadienyl)trimethylplatinum(IV), (1,2,3,4,5-pentamethylcyclopentadienyl)trimethylplatinum(IV), (cyclopentadienyl)dimethylethylplatinum(IV), (cyclopentadienyl)dimethylacetylplatinum(IV), (trimethylsilylcyclopentadienyl)trimethylplatinum(IV), (methoxycarbonylcyclopentadienyl)trimethylplatinum(IV), and (dimethylphenylsilylcyclopentadienyl)trimethylplatinum(I V), and examples of the catalyst of β-diketonato ligand type include a β-diketonatoplatinum(II) or platinum(IV) complex, and in particular specific examples thereof include trimethyl(acetylacetonato)platinum(IV), trimethyl(3,5-heptanedionato)platinum(IV), trimethyl (methylacetoacetate)platinum(IV), bis(2,4-pentanedionato)platinum(II), bis(2,4-hexanedionato)platinum (II), bis(2,4-heptanedionato)platinum(II), bis(3,5-heptanedionato)platinum(II), bis(1-phenyl-1,3-butanedionato)platinum (II), bis(1,3-diphenyl-1,3-propanedionato)platinum(II), and bis(hexafluoroacetylacetonato)platinum(II).

In using these catalysts that are solid catalysts, they can be used in solid form, but in order to obtain a more uniform cured product, it is preferable to use them dissolved in a suitable solvent. The suitable solvent herein means a solvent that is soluble in any or all of components (A), (B), and (C), and is suitable for a working environment and process.

The amount of component (D) added is an effective amount, and is usually 0.1 to 5,000 ppm in terms of metal atom amount and preferably 1 to 1,000 ppm, based on the total mass of components (A), (B), and (C). The amount added of 0.1 ppm or more does not deteriorate the curability of the composition, does not reduce a crosslink density, and does not deteriorate holdability. The amount added of 5,000 ppm or less makes it possible to inhibit a side reaction such as dehydrogenation upon curing and also to prolong a usable time of a treating liquid.

[Component (E)]

Component (E) is a phenolic antioxidant, and preferably has a chemical structural formula not containing a phosphorus atom or a sulfur atom in order to avoid inhibition of hydrosilylation reaction. Thus, it is essential in the present invention that the curable silicone resin composition contains a phenolic antioxidant not containing a phosphorus atom or a sulfur atom.

Preferred examples of such an antioxidant include 4,4'-dihydroxy-3,3',5,5'-tetraisopropylbiphenyl, 3-(3,5-di-tert-butyl-4-hydroxyphenyl)-N'-[3-(3,5-di-tert-butyl-4-hydroxyphenyl)propanoyl]propanehydrazide, 4,6-di-tert-butylbenzene-1,3-diol, bis[3-[3-(tert-butyl)-4-hydroxy-5-methylphenyl]propanoic acid] 2,4,8,10-tetraoxaspiro[5.5]undecane-3,9-diylbis(2-methylpropane-2,1-diyl), 2,2'-methylenebis[6-(1-methylcyclohexyl)-p-cresol],octadecyl 3-(3,5-di-tert-butyl-4-hydroxyphenyl) propionate, triethylene glycol bis[3-(3-tert-butyl-4-hydroxy-5-methylphenyl)propionate], 2,4,6-tris(2,4-dihydroxyphenyl)-1,3,5-triazine, 2,6-di-tert-butyl-4-ethylphenol, 2,2'-methylenebis(6-tert-butyl-4-ethylphenol), 2,6-di-tert-butyl-4-methoxyphenol, 4,4'-butylidenebis(6-tert-butyl-m-cresol), 6-tert-butyl-2,4-xylenol, 3-(3,5-di-tert-butyl-4-hydroxyphenyl) propionic acid, 2,6-di-tert-butylphenol, 4,4'-dihydroxy-3,3',5,5'-tetraisopropylbiphenyl, 2,5-bis(1,1,3,3-tetramethylbutyl) hydroquinone, N,N'-(hexane-1, 6-diyl)bis[3-(3,5-di-tert-butyl-4-hydroxyphenyl)propanamide], pentaerythritol tetrakis[3-(3,5-di-tert-butyl-4-hydroxyphenyl)propionate], 2,5-di-tert-amylhydroquinone, 2,6-di-tert-butyl-p-cresol,

2,6-di-tert-butyl-4-methoxyphenol, 2,2'-methylenebis(6-cyclohexyl-p-cresol), 4-(hexyloxy)-2,3,6-trimethylphenol, hexadecyl 3,5-di-tert-butyl-4-hydroxybenzoate, 2,2',6,6'-tetra-tert-butyl-4,4'-dihydroxybiphenyl, 2,4,6-tris(2,4-dihydroxyphenyl)-1,3,5-triazine, 2,5-di-tert-butylhydroquinone, 1,3,5-tris(3,5-di-tert-butyl-4-hydroxybenzyl)-1, 3, 5-triazine-2,4,6 (1H,3H,5H)-trione, and ethylene bis-(oxyethylene) bis(3-(5-tert-butyl-4-hydroxy-m-tolyl)propionate), and among them, hindered phenolic antioxidants such as 4,4'-dihydroxy-3,3',5,5'-tetraisopropylbiphenyl, 3-(3,5-di-tert-butyl-4-hydroxyphenyl)-N'-[3-(3,5-di-tert-butyl-4-hydroxyphenyl)propanoyl]propanehydrazide, bis[3-[3-(tert-butyl)-4-hydroxy-5-methylphenyl]propanoic acid] 2,4,8,10-tetraoxaspiro[5.5]undecane-3,9-diylbis(2-methylpropane-2,1-diyl), 2,2'-methylenebis [6-(1-methylcyclohexyl) -p-cresol], octadecyl 3-(3,5-di-tert-butyl-4-hydroxyphenyl) propionate, triethylene glycol bis [3-(3-tert-butyl-4-hydroxy-5-methylphenyl)propionate], 2,6-di-tert-butyl-4-ethylphenol, 2,2'-methylenebis(6-tert-butyl-4-ethylphenol), 2,6-di-tert-butyl-4-methoxyphenol, 6-tert-butyl-2,4-xylenol, 3-(3,5-di-tert-butyl-4-hydroxyphenyl)propionic acid, 2,6-di-tert-butylphenol, 4,4'-dihydroxy-3,3',5,5'-tetraisopropylbiphenyl, N,N'-(hexane-1,6-diyl)bis[3-(3,5-di-tert-butyl-4-hydroxyphenyl)propanamide], pentaerythritol tetrakis[3-(3,5-di-tert-butyl-4-hydroxyphenyl) propionate], 2,6-di-tert-butyl-p-cresol, 2,6-di-tert-butyl-4-methoxyphenol, 2,2'-methylenebis(6-cyclohexyl-p-cresol), 4-(hexyloxy)-2,3,6-trimethylphenol, hexadecyl 3,5-di-tert-butyl-4-hydroxybenzoate, 2,2',6,6'-tetra-tert-butyl-4,4'-dihydroxybiphenyl, 2,4,6-tris(2,4-dihydroxyphenyl)-1,3,5-triazine, 2,5-di-tert-butylhydroquinone, 1,3,5-tris(3,5-di-tert-butyl-4-hydroxybenzyl)-1,3,5-triazine-2,4,6(1H,3H,5H)-trione, and ethylene bis(oxyethylene) bis-(3-(5-tert-butyl-4-hydroxy-m-tolyl)propionate) are preferred because they are more likely to provide an antioxidant effect.

In case of using these antioxidants, which are solid antioxidants, they can be used in solid form, but in order to obtain a more uniform cured product, it is preferable to use them dissolved in an appropriate solvent.

The amount of component (E) added is an effective amount, and is usually 1 to 100,000 ppm, preferably 10 to 10,000 ppm, based on the total mass of components (A), (B), and (C). The amount added of 1 ppm or more can improve the heat resistant stability of a cured product and the amount added of 100,000 ppm or less can improve the heat resistant stability without curability and physical properties after curing being affected.

[Component (F)]

The curable silicone resin composition may further contain a reaction control agent (hydrosilylation reaction control agent) as component (F). The reaction control agent is optionally added, if necessary, in order to prevent the composition from increasing a viscosity or causing gelation when the composition is prepared, or applied to a substrate by coating.

Examples of the reaction control agent include 3-methyl-1-butyn-3-ol, 3-methyl-1-pentyn-3-ol, 3,5-dimethyl-1-hexyn-3-ol, 1-ethynylcyclohexanol, 3-methyl-3-trimethylsiloxy-1-butyne, 3-methyl-3-trimethylsiloxy-1-pentyne, 3,5-dimethyl-3-trimethylsiloxy-1-hexyne, 1-ethynyl-1-trimethylsiloxycyclohexane, bis(2,2-dimethyl-3-butynyloxy)dimethylsilane, 1,3,5,7-tetramethyl-1,3,5,7-tetravinylcyclotetrasiloxane, and 1,1,3,3-tetramethyl-1,3-divinyldisiloxane. Among these, 1-ethynylcyclohexanol and 3-methyl-1-butyn-3-ol are preferred.

When the curable silicone resin composition contains the component (F), the content thereof should be adjusted to an optimum amount because its control ability differs depending on the chemical structure, however, taking into consideration the effects on curability, storage stability, and physical properties after curing, the content of component (F) is preferably 0.001 to 10 parts by mass and more preferably 0.01 to 10 parts by mass, based on the total mass of the components (A), (B), and (C). The content of the component (F) within the above range results in prolonged usable time, long-term storage stability, and favorable curability and workability of the composition.

In the curable silicone resin composition, an organopolysiloxane that includes a $R^A_3SiO_{0.5}$ unit (wherein, $R^A$ is each independently an unsubstituted or substituted monovalent hydrocarbon group having 1 to 10 carbon atoms) and a $SiO_2$ unit, and has a mole ratio of the $R^A_3SiO_{0.5}$ unit to the $SiO_2$ unit ($R^A_3SiO_{0.5}/SiO_2$) of 0.3 to 1.8, may be further included. The amount of organopolysiloxane added is preferably 0 to 500 parts by mass based on 100 parts by mass of component (A).

In the curable silicone resin composition, a filler such as silica may be added in order to further improve the physical strength of a temporary adhesive layer to be obtained from the composition.

The curable silicone resin composition may be used in solution form by adding a solvent to the composition, for reasons such as improvement on workability and mixability, resulting from having reduced the viscosity of the composition, adjustment of film thickness of the temporary adhesive layer, and the like. The solvent to be used is not particularly limited as long as it can dissolve the above components, but for example, hydrocarbon solvents such as pentane, hexane, cyclohexane, isooctane, nonane, decane, p-menthane, pinene, isododecane, and limonene are preferred.

Examples of the method of forming a solution includes a method for preparing the curable silicone resin composition and finally adding a solvent to adjust the viscosity to the desired level, and a method for preliminarily diluting highly viscous components (A), (B), and/or (C) with a solvent to improve workability and mixability, and then mixing the remaining component. Also, a mixing method in forming a solution may be appropriately selected from mixing means such as a shaking mixer, a magnetic stirrer, and various mixers, based on the viscosity and workability of the composition, to

then carry out it.

The amount of solvent compounded may be appropriately set from the viewpoint of adjusting the viscosity of the composition and workability, a film thickness of the temporary adhesive layer, and the like, but for example, it is preferably 5 to 900 parts by mass and more preferably 10 to 400 parts by mass, based on 100 parts by mass of the curable silicone resin composition.

The temporary adhesive layer can be formed by coating a surface of a substrate with the curable silicone resin composition by a method such as spin-coating or roll coating. Of these, when forming the temporary adhesive layer on a substrate by a method such as spin-coating, it is preferable to coat the substrate with the curable silicone resin composition in solution form.

From the viewpoint of coatability, the viscosity at 25°C of the curable silicone resin composition in solution form is preferably 1 to 100,000 mPa·s and more preferably 10 to 10,000 mPa ·s.

The curable silicone resin composition usually has a 180° peel strength at 25°C after curing of 2 to 100 gf, preferably 3 to 50 gf, and more preferably 5 to 30 gf, when a test specimen with a width of 25 mm (for example, a glassy test specimen) is peeled off from a silicon substrate. The 180° peel strength of 2 gf or more makes it unlikely for a wafer to have a risk of being misaligned upon wafer grinding, and the 180° peel strength of 100 gf or less facilitates a wafer to be peeled off.

The curable silicone resin composition has a storage modulus at 25°C after curing of 1,000 Pa or more and 1,000 MPa or less and preferably 10,000 Pa or more and 100 MPa or less. When the storage modulus is 1,000 Pa or more, the film to be formed will be robust, causing no risk of misalignment of wafer upon wafer griding or wafer cracks accompanying the misalignment, and the deforming stress of 1,000 MPa or less can reduce the deforming stress during a wafer thermal process such as CVD and provides stability upon thermal process of wafers.

When forming a laminate of a wafer (substrate) /temporary adhesive layer/support, coating a surface on the wafer (substrate) side with the curable silicone resin composition or coating a surface on the support side therewith allows an interface upon peeling after formation of laminate to be selectively controlled. In other words, when coating a wafer (substrate) with the composition to form a bonded body with a support and then peeling off the bonded body, it can be selectively peeled off between the wafer (substrate) and the temporary adhesive layer. In this case, the temporary adhesive layer remains on the support as a residue, making it possible to simplify the subsequent wafer (substrate) cleaning process, which is preferable in terms of improving workability. When an object to be coated with the curable silicone resin composition is changed to a support and a bonded body with the wafer (substrate) is peeled off, it can be selectively peeled off at an interface between the temporary adhesive layer and the support. In this case, the residue of the temporary adhesive layer remains on the wafer (substrate) side, which may lead to deterioration in workability in the subsequent wafer (substrate) cleaning process. However, when the surface on the support side is coated with the curable silicone resin composition,the temporary adhesive is less susceptible to the influence of the wafer (substrate) to be used, such as inhibition of curing via a hydrosilylation reaction, facilitating it to function as a stable temporary adhesive, which is preferred.

[Method for producing thin wafer]

The method for producing a thin wafer of the present invention is characterized in that for temporary adhesion between a wafer having a semiconductor circuit or the like and a support, the temporary adhesive for wafer processing is used.

The method for producing a thin wafer of the present invention includes the following steps (a) to (e) .

[Step (a)]

The step (a) is a temporary adhesion step of allowing a circuit-forming surface of a wafer having the circuit-forming surface on its front surface and a circuit-free surface on its back surface to peelably adhere to a support using the temporary adhesive for wafer processing to form a wafer laminate.

Specifically, any one of the following methods is applied: a method for using the temporary adhesive for wafer processing to form a temporary adhesive layer on a front surface of the wafer and bonding a support and the front surface of the wafer together via the temporary adhesive layer; a method for using the temporary adhesive for wafer processing to form a temporary adhesive layer on a surface of a support and bonding the support and the front surface of the wafer together via the temporary adhesive layer; or a method for forming temporary adhesive layers on both a front surface of the wafer and a surface of a support using the temporary adhesive for wafer processing and bonding the support and the surface of the wafer via the temporary adhesive layer.

A wafer applicable to the present invention is usually a semiconductor wafer. Examples of the semiconductor wafer include not only a silicon wafer but also a germanium wafer, a gallium-arsenide wafer, a gallium-phosphorus wafer, and a gallium-arsenide-aluminum wafer. A thickness of the wafer is not particularly limited, but is typically 600 to 800 μm and more typically 625 to 775 μm.

The support that is a substrate such as a silicon wafer, a glass plate, or a quartz wafer can be used, but is not limited thereto. In the present invention, when curing the curable silicone resin composition without irradiation with light through a support, the support may not have transparency to light, whereas when carrying out light irradiation through a support to cure the curable silicone resin composition, the support for use preferably has transparency to light.

The temporary adhesive layer may be formed by stacking the curable silicone resin composition formed into a film on a wafer or a support, or may be formed by being coated with the curable silicone resin composition by a method such as spin-coating or roll coating. In a case in which the curable silicone resin composition is a solution containing a solvent, following coating, it is prebaked at a temperature of preferably 40 to 200°C and more preferably 50 to 150°C, depending on the volatilization conditions of the solvent, and then used.

The temporary adhesive layer is preferably formed to a film thickness of 0.1 to 500 μm, preferably 1.0 to 200 μm, and then used. The film thickness of the layer of 0.1 μm or more, when a surface of a support is coated therewith, allows the layer to be coated on the entire substrate without leaving any uncoated areas. The temporary adhesive layer with a film thickness of 500 μm or less, on the other hand, can withstand the grinding process when forming a thin wafer.

An example of the method for allowing the support and the front surface of the wafer to be bonded together via the temporary adhesive layer includes a method of uniform pressure bonding under reduced pressure at a temperature range of preferably 10 to 200°C and more preferably 20 to 150°C.

The pressure when a wafer on which the temporary adhesive layer has been formed and the support undergo pressure bonding is preferably 0.01 to 10 MPa and more preferably 0.1 to 1.0 MPa, depending on the viscosity of the temporary adhesive layer. The pressure of 0.01 MPa or more allows a circuit-forming surface and a space between a wafer and a support to be filled with the temporary adhesive layer, and the pressure of 10 MPa or less causes no risk of wafer cracking or deterioration of flatness of a wafer and the temporary adhesive layer, resulting in favorable subsequent wafer processing.

The wafers can be bonded together using a commercially available wafer bonder, such as EVG520IS or 850TB, manufactured by EVG Corporation or XBS300 manufactured by SUSS MicroTec SE.

[Step (b)]

The step (b) is a step of curing the temporary adhesive layer. After forming of the wafer laminate using the thermosetting silicone resin composition, the temporary adhesive layer is cured by heating at preferably 50 to 300°C and more preferably 100 to 200°C, for preferably 1 minute to 4 hours and more preferably 5 minutes to 2 hours.

After forming of the laminate substrate using a photocurable resin composition, the temporary adhesive layer may be photocured while being irradiated with light from the side of a support having transparency to light, or the laminate substrate may be formed of a photocurable silicone resin composition that has been preliminarily irradiated with light, and then cured. The type of active light in this case is not particularly limited, but ultraviolet light is preferably used, and ultraviolet light with a wavelength of 300 to 400 nm is more preferably used. The ultraviolet radiation dosage (illuminance) is desirably 100 $mJ/cm^2$ to 100,000 $mJ/cm^2$, preferably 500 $mJ/cm^2$ to 10,000 $mJ/cm^2$, and more preferably 1,000 to 5,000 $mJ/cm^2$, in terms of accumulated light amount, in order to obtain favorable curability. The ultraviolet radiation dosage (illuminance) that is equal to or more than the lower limit of the above range provides sufficient energy to activate the photoactivated hydrosilylation reaction catalyst in the temporary adhesive layer, making it possible to obtain a sufficiently cured product. The ultraviolet radiation dosage (illuminance) that is equal to or less than the upper limit of the above range can provide a sufficiently cured product with sufficient energy being irradiated to the composition, without decomposition of components in a polymer layer or inactivation of a part of the catalyst due to the energy irradiation.

In ultraviolet irradiation, light having a plurality of emission spectra or light having a single emission spectrum may be used. Also, the single emission spectrum may have a broad spectrum in the range of 300 nm to 400 nm. The light having a single emission spectrum is light having a peak (i.e., the maximum peak wavelength) in the range of 300 nm to 400 nm, preferably 350 nm to 380 nm. Examples of light sources that irradiate such light include an ultraviolet light emitting diode (UV-LED) and an ultraviolet light emitting semiconductor element light source such as an ultraviolet light emitting semiconductor laser.

Examples of the light sources that irradiate with light having a plurality of emission spectra include lamps such as a metal halide lamp, a xenon lamp, a carbon arc lamp, a chemical lamp, a sodium lamp, a low-pressure mercury lamp, a high-pressure mercury lamp, and an extra-high-pressure mercury lamp; a gas laser such as a nitrogen laser; a liquid laser of an organic dye solution; and a solid-state laser in which a rare earth ion is incorporated into inorganic single crystals.

When the light has a peak in the wavelength region shorter than 300 nm in an emission spectrum, or when a wavelength in the wavelength region shorter than 300 nm, which has an irradiance greater than 5% of that of the maximum peak wavelength in the emission spectrum (for example, when the emission spectrum is broad over a wide wavelength region) is present, and when a substrate having transparency to light for wavelengths shorter than 300 nm, such as a quartz wafer, is used as a support, it is preferable to remove light with wavelengths in the wavelength region shorter than 300 nm using an optical filter in order to obtain a sufficiently cured product. In this manner, the irradiance of each

wavelength in the wavelength region shorter than 300 nm is set to 5% or less, preferably 1% or less, more preferably 0.1% or less, and still more preferably 0%, of the irradiance of the maximum peak wavelength. It is to be noted that when a plurality of peaks is present in the wavelength region from 300 nm to 400 nm in an emission spectrum, a peak wavelength exhibiting the maximum absorbance among them is set to the maximum peak wavelength. The optical filter is not particularly limited as long as it cuts wavelengths shorter than 300 nm, and any publicly known optical filter may be used. For example, a 365 nm bandpass filter or the like may be used. Incidentally, an illuminance and spectral distribution of ultraviolet light can be measured using a spectroradiometer, for example, USR-45D (manufactured by Ushio Inc.).

The light irradiation apparatus is not particularly limited, but for example, a spot-type irradiation apparatus, a surface-type irradiation apparatus, a line-type irradiation apparatus, a conveyor-type irradiation apparatus, and the like can be used.

When curing the photocurable silicone resin composition, a light irradiation time depends on the illuminance as well and cannot be specified in general, however, when the light irradiation time is adjusted to, for example, 1 to 300 seconds, preferably 10 to 200 seconds, and more preferably 30 to 150 seconds, it is also appropriately short and does not cause any particular problems in a working process. Also, the photocurable silicone resin composition that has been irradiated with light undergoes gelation after irradiation of 1 to 120 minutes and particularly 5 to 60 minutes. It is to be noted that the gelation used herein means a state in which a curing reaction of the photocurable silicone resin composition partially has proceeded, and the composition has lost its flowability.

Moreover, a curing rate of the photocurable silicone resin composition after irradiation with light depends on an environmental temperature, so that it is preferable to leave to stand the above-described wafer processed body (laminate substrate) at a temperature of preferably 20 to 150°C and more preferably 30 to 100°C, from the viewpoint of improved workability.

In this manner, a wafer laminate is obtained, which includes a support, a temporary adhesive layer obtained from a temporary adhesive for wafer processing stacked on the support, and a wafer having a circuit-forming surface on its front surface and a circuit-free surface on its back surface, wherein the temporary adhesive layer is peelably adhered to the front surface of the wafer.

[Step (c)]

Step (c) is the step of grinding or polishing a circuit-free surface of the wafer that has temporarily adhered to a support (i.e., the wafer of a wafer laminate), that is, the step of grinding a back surface side of the wafer of the wafer laminate obtained in the above step to make the wafer thin. The method for grinding the back surface of the wafer is not particularly limited, and a publicly known grinding method is adopted. Grinding is preferably performed while spraying water on a wafer and grinding wheel (diamond or the like). An example of an apparatus for grinding a back surface of a wafer includes a DAG-810 (product name) manufactured by Disco Corporation. The back surface side of the wafer may also be subjected to chemical mechanical polishing (CMP).

[Step (d)]

The step (d) is a step of subjecting a circuit-free surface of a wafer laminate in which the circuit-free surface has been ground in the step (c) to processing. In other words, it is the step of subjecting a circuit-free surface of a wafer laminate that has been made thin by back surface grinding to processing. This step includes various processes to be used at wafer level. Examples thereof include electrode formation, metal wiring formation, and protective film formation. More specific examples thereof include conventionally publicly known processes such as metal sputtering for forming an electrode and the like, wet etching for etching a metal sputtered layer, coating with a resist to serve as a mask for forming a metal wiring, light exposure, and development to form a pattern, resist stripping, dry etching, forming of metal plating, silicon etching for forming a TSV, and forming of oxide film on a silicon surface.

[Step (e)]

The step (e) is a step of peeling off the wafer subjected to the processing in step (d) from a support, that is, a step of peeling off the wafer from the support after various processing has been performed on a thinned wafer and before dicing. This peeling step is generally performed under relatively mild conditions from room temperature to approximately 60°C. Examples of the peeling method include a method for horizontally fixing one side of a wafer or a support of a wafer laminate and lifting the other side at a certain angle for the horizontal direction, and a method for attaching a protective film on a ground surface of a wafer that has been ground and peeling off the wafer and the protective film from the wafer laminate in a peeling manner. When the peeling step is performed by these peeling manners, it is usually performed at room temperature.

Also step (e) preferably includes

step (e1) of attaching a dicing tape to a wafer surface of a processed wafer;
step (e2) of vacuum-adsorbing a surface of the dicing tape to an adsorption surface; and
step (e3) of peeling off the support from the processed wafer in a peel-off manner at a temperature of the adsorption surface in the range of 10 to 100°C. In this manner, the support can be easily peeled off from the processed wafer, and the subsequent dicing step can be easily performed.

Furthermore, following step (e),
step (f) of removing the temporary adhesive layer remaining on a circuit-forming surface of the peeled wafer, is preferably carried out. The temporary adhesive layer may partially remain on the circuit-forming surface of the wafer peeled off from the support in step (e), and the temporary adhesive layer can be removed, for example, by cleaning the wafer.
In this step (f), any cleaning liquid that dissolves the silicone resin of the temporary adhesive layer can be used, and specific examples thereof include pentane, hexane, cyclohexane, decane, isononane, p-menthane, pinene, isododecane, and limonene. These solvents may be used singly or in combination of two or more thereof.
When the temporary adhesive layer is difficult to remove, bases or acids may be added to the cleaning liquid. The bases including amines such as ethanolamine, diethanolamine, triethanolamine, triethylamine, and ammonia; and ammonium salts such as tetramethylammonium hydroxide, can be used. The acids that are organic acids such as acetic acid, oxalic acid, benzenesulfonic acid, and dodecylbenzenesulfonic acid can be used. The amount of base or acid added is such that the concentration in the cleaning liquid is preferably 0.01 to 10% by mass and more preferably 0.1 to 5% by mass. Also, an existing surfactant may be added to improve the removability of the remaining matter. Furthermore, the SPIS-TA-CLEANER series (manufactured by Shin-Etsu Chemical Co., Ltd.), which is available as a wafer cleaning agent, may also be suitably used.
Examples of the wafer cleaning method include a method of cleaning with a paddle using the cleaning liquid, a method of cleaning by spraying, and a method of immersing in a cleaning liquid tank. A temperature upon cleaning is preferably 10 to 80°C and more preferably 15 to 65°C. After having dissolved the temporary adhesive layer with these cleaning liquids, a final rinse with water or alcohol may be performed followed by drying treatment, if necessary.
The thickness of the thin wafer obtained by the production method of the present invention is typically 5 to 300 μm and more typically 10 to 100 μm.

EXAMPLE

The present invention will be described in more detail below with reference to Preparation Examples, Comparative Preparation Examples, Examples, and Comparative Examples, but the present invention is not limited to these Examples. It is to be noted that the viscosity is a value measured at 25°C using a rotational viscometer.

[1] Preparation of curable silicone resin solution

[Preparation Example 1]

To a solution of 100 parts by mass of dimethylpolysiloxane having an Mn of 30,000 and consisting of 97.5 mol% of a $(CH_3)_2SiO_{2/2}$ unit (D unit) and 2.5 mol% of a $(CH_2{=}CH)(CH_3)SiO_{2/2}$ unit ($D^{Vi}$ unit) and 200 parts by mass of toluene, were added a solution of 50 parts by mass of vinylmethylpolysiloxane having an Mn of 7,000 and a resin structure consisting of 50 mol% of a $SiO_{4/2}$ unit (Q unit), 48 mol% of a $(CH_3)_3SiO_{1/2}$ unit (M unit), and 2 mol% of a $(CH_2{=}CH)(CH_3)_2SiO_{1/2}$ unit ($M^{Vi}$ unit) and 100 parts by mass of toluene, a solution of 21 parts by mass of an organohydrogenpolysiloxane having an Mn of 2,400 and consisting of 83.9 mol% of a $(CH_3)_2SiO_{2/2}$ unit (D unit) and 16.1 mol% of a $(CH_3)HSiO_{2/2}$ unit ($D^H$ unit), 50 parts by mass of dimethylpolysiloxane blocked with trimethylsiloxy groups at both ends of the molecular chain, wherein a 30% by mass toluene solution thereof has a viscosity (25°C) of 30,000 mPa·s, and 120 parts by mass of toluene, 0.6 parts by mass of 1-ethynylcyclohexanol, as well as a solution of 0.1 parts by mass of an antioxidant represented by the following formula (M-1) and 0.4 parts by mass of toluene, and the mixture was mixed. Furthermore, 0.4 parts by mass of a hydrosilylation reaction catalyst CAT-PL-5 (platinum concentration: 1.0% by mass, manufactured by Shin-Etsu Chemical Co., Ltd.) was added thereto, and the mixture was filtered through a 0.2 μm membrane filter to prepare a thermosetting silicone resin solution A1. The viscosity of resin solution A1 at 25°C was 2,300 mPa·s.
The value of the total of the SiH groups in component (B) to the total of the alkenyl groups in component (A) (Si-H/Si-Vi) in this Preparation Example 1 is calculated using the following formula:
The value of the total of SiH groups in component (B) to the total of alkenyl groups in component (A) (Si-H/Si-Vi) in this Preparation Example 1 is calculated using the following formula:

Amount of Si-Vi from PDMS (mol) (amount of PDMS added/PDMS molecular weight) × <PDMS molecular weight/{[(D unit molecular weight) × (D unit mol%/100)] + [($D^{Vi}$ unit molecular weight) × ($D^{vi}$ unit mol%/100)]}> × ($D^{vi}$ unit mol%/100) (1)

Amount of Si-Vi from PVMS of resin structure with Vi group (mol) (amount of PVMS added/PVMS molecular weight) × <PVMS molecular weight/{[(Q unit molecular weight) × (Q unit mol%/100)] + [(M unit molecular weight) × (M unit mol%/100)] + [($M^{Vi}$ unit molecular weight) × ($M^{Vi}$ unit mol%/100)]}> × ($M^{Vi}$ unit mol%/100) (2)

Amount of Si-H from POHS (mol) (amount of POHS added/POHS molecular weight) × <PVMS molecular weight/{ [(D unit molecular weight) × (D unit mol%/100)] + [($D^H$ unit molecular weight) × ($D^H$ unit mol%/100)]} > × ($D^H$ unit mol%/100) (3)

(in the above-described formulae, PDMS: dimethylpolysiloxane, PVMS: vinylmethylpolysiloxane having a resin structure, POHS: organohydrogenpolysiloxane).

The Si-H/Si-Vi (mole ratio) in Preparation Example 1 obtained from (1) to (3) above is 1.0.

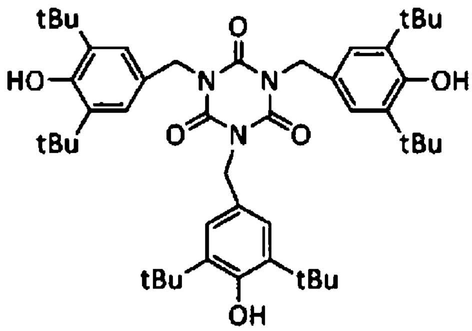

(M− 1)

[Preparation Example 2]

To a solution of 70 parts by mass of dimethylpolysiloxane having an Mn of 30,000 and consisting of 97.5 mol% of a $(CH_3)_2SiO_{2/2}$ unit (D unit) and 2.5 mol% of a $(CH_2=CH)(CH_3)SiO_{2/2}$ unit ($D^{Vi}$ unit), 30 parts by mass of dimethylpolysiloxane having an Mn of 60,000 and consisting of 99.85 mol% of a $(CH_3)_2SiO_{2/2}$ unit (D unit) and 0.15 mol% of a $(CH_2=CH)(CH_3)SiO_{2/2}$ unit ($D^{Vi}$ unit) and 200 parts of toluene, were added a solution of 50 parts by mass of vinylmethylpolysiloxane having an Mn of 7,000 and a resin structure consisting of 50 mol% of a $SiO_{4/2}$ unit (Q unit), 48 mol% of a $(CH_3)_3SiO_{1/2}$ unit (M unit), and 2 mol% of a $(CH_2=CH)(CH_3)_2SiO_{1/2}$ unit ($M^{Vi}$ unit) and 100 parts by mass of toluene, 25 parts by mass of an organohydrogenpolysiloxane having an Mn of 2,400 and consisting of 16.1 mol% of a $(CH_3)HSiO_{2/2}$ unit ($D^H$ unit), 30 parts by mass of dimethylpolysiloxane blocked with trimethylsiloxy groups at both ends of the molecular chain, wherein a 30% by mass toluene solution thereof has a viscosity (25°C) of 5,000 mPa·s, 0.6 parts by mass of 1-ethynylcyclohexanol, as well as a solution of 0.1 parts by mass of an antioxidant represented by the following formula (M-2) and 0.4 parts by mass of toluene, and the mixture was mixed. Furthermore, 0.4 parts by mass of a hydrosilylation reaction catalyst CAT-PL-5 was added thereto, and the mixture was filtered through a 0.2 μm membrane filter to prepare thermosetting silicone resin solution A2. The viscosity of resin solution A2 at 25°C was 1,800 mPa·s. Also, the Si-H/Si-Vi (mole ratio) in Preparation Example 2 is 1.5.

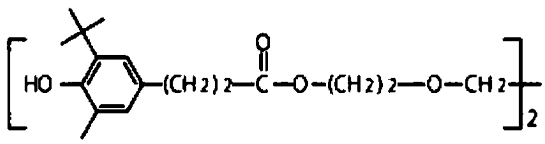

(M− 2)

[Preparation Example 3]

To a solution of 100 parts by mass of dimethylpolysiloxane having an Mn of 30,000 and consisting of 97.5 mol% of

a $(CH_3)_2SiO_{2/2}$ unit (D unit) and 2.5 mol% of a $(CH_2=CH)(CH_3)SiO_{2/2}$ unit ($D^{Vi}$ unit) and 200 parts by mass of toluene was added a solution of 50 parts by mass of vinylmethylpolysiloxane having an Mn of 7,000 and a resin structure consisting of 50 mol% of a $SiO_{4/2}$ unit (Q unit), 48 mol% of a $(CH_3)_3SiO_{1/2}$ unit (M unit), and 2 mol% of a $(CH_2=CH)(CH_3)_2SiO_{1/2}$ unit ($M^{Vi}$ unit) and 100 parts by mass of toluene, a solution of 15 parts by mass of an organohydrogenpolysiloxane having an Mn of 2,400 and consisting of 16.1 mol% of a $(CH_3)HSiO_{2/2}$ unit ($D^H$ unit), 20 parts by mass of dimethylpolysiloxane blocked with trimethylsiloxy groups at both ends of the molecular chain, wherein a 30% by mass toluene solution thereof has a viscosity (25°C) of 100,000 mPa·s and 80 parts by mass of toluene, 0.6 parts by mass of 1-ethynylcyclohexanol, as well as a solution of 0.1 parts by mass of an antioxidant represented by the following formula (M-3) and 0.4 parts by mass of toluene, and the mixture was mixed. Furthermore, 0.4 parts by mass of a hydrosilylation reaction catalyst CAT-PL-5 was added thereto, and the mixture was filtered through a 0.2 μm membrane filter to prepare thermosetting silicone resin solution A3. The viscosity of resin solution A3 at 25°C was 2,800 mPa·s. Also, the Si-H/Si-Vi (mole ratio) in Preparation Example 3 is 0.7.

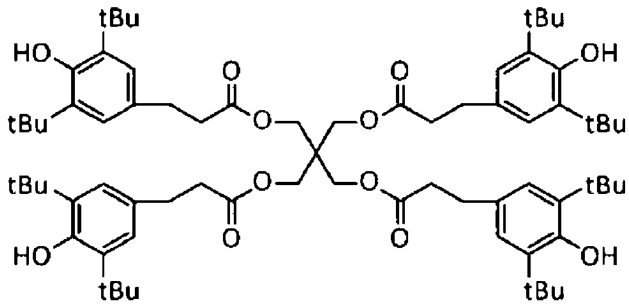

(M− 3)

[Preparation Example 4]

Thermosetting silicone resin solution A4 was prepared in the same manner as in Preparation Example 3 described above, except that the amount of antioxidant added, represented by formula (M-3) above was changed from 0.1 parts by mass to 0.05 parts by mass, and the organohydrogenpolysiloxane having an Mn of 2,400 and consisting of 16.1 mol% of a $(CH_3)HSiO_{2/2}$ unit ($D^H$ unit) was changed from 15 parts by mass to 21 parts by mass, respectively in Preparation Example 3 described above. The viscosity of resin solution A4 at 25°C was 2,400 mPa ·s. The Si-H/Si-Vi (mole ratio) in Preparation

Example 4 is 1.0.

[Preparation Example 5]

Thermosetting silicone resin solution A5 was prepared in the same manner as in Preparation Example 4 described above, except that the amount of antioxidant added, represented by formula (M-3) above was changed from 0.1 parts by mass to 0.4 parts by mass in Preparation Example 4 described above. The viscosity of resin solution A5 at 25°C was 2,400 mPa·s. Also, the Si-H/Si-Vi (mole ratio) in Preparation Example 5 is 1.0.

[Preparation Example 6]

Photocurable silicone resin solution A6 was prepared in the same manner as in Preparation Example 1 described above, except that a toluene solution of a photoactivated hydrosilylation reaction catalyst; (methylcyclopentadienyl) trimethylplatinum(IV) (platinum concentration: 1.0% by mass) (0.4 parts by mass) was added instead of the hydrosilylation reaction catalyst CAT-PL-5 (0.4 parts by mass) in Preparation Example 1 described above. The viscosity of resin solution A6 at 25°C was 2,300 mPa·s. The Si-H/Si-Vi (mole ratio) in Preparation Example 6 is 1.0.

[Preparation Example 7]

Photocurable silicone resin solution A7 was prepared in the same manner as in Preparation Example 2 described above, except that a toluene solution of a photoactivated hydrosilylation reaction catalyst; (methylcyclopentadienyl) trimethylplatinum(IV) (platinum concentration: 1.0% by mass) (0.4 parts by mass) was added instead of the hydrosilylation reaction catalyst CAT-PL-5 (0.4 parts by mass) in Preparation Example 2 described above. The viscosity of resin solution A7 at 25°C was 1,800 mPa·s. The Si-H/Si-Vi (mole ratio) in Preparation Example 7 is 1.5.

[Comparative Preparation Example 1]

Thermosetting silicone resin solution CA1 was prepared in the same manner as in Preparation Example 1 described above, except that the solution of 0.1 parts by mass of the antioxidant represented by formula (M-1) above and 0.4 parts by mass of toluene was not added in Preparation Example 1 described above. The viscosity of resin solution CA1 at 25°C was 2,400 mPa·s. The Si-H/Si-Vi (mole ratio) in Comparative Preparation Example 1 is 1.0.

[Comparative Preparation Example 2]

Thermosetting silicone resin solution CA2 was prepared in the same manner as in Preparation Example 1 described above, except that 0.1 parts by mass of an antioxidant represented by the following formula (M-4) was added instead of 0.1 parts by mass of the antioxidant represented by formula (M-1) above in Preparation Example 1 described above. The viscosity of resin solution CA2 at 25°C was 2,300 mPa·s. The Si-H/Si-Vi (mole ratio) in this Comparative Preparation Example 2 is 1.0.

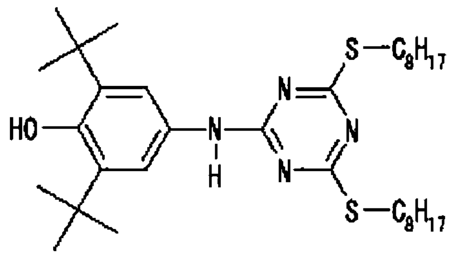

(M-4)

[Comparative Preparation Example 3]

Photocurable silicone resin solution CA3 was prepared in the same manner as in Preparation Example 6 described above, except that 0.1 parts by mass of an antioxidant represented by the following formula (M-5) was added instead of 0.1 parts by mass of the antioxidant represented by formula (M-1) above in Preparation Example 6 described above. The viscosity of resin solution CA3 at 25°C was 2,300 mPa·s. The Si-H/Si-Vi (mole ratio) in Comparative Preparation Example 3 is 1.0.

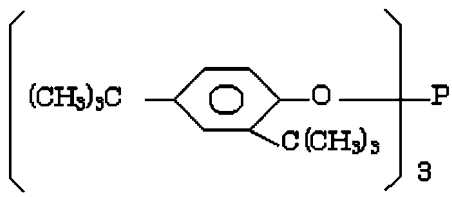

(M-5)

[2] Fabrication and evaluation of wafer laminate

[Examples 1 to 7 and Comparative Examples 1 to 3]

A 200 mm-diameter silicon wafer (thickness: 725 μm) with copper posts of 10 μm height and 40 μm diameter formed on the entire front surface, was spin-coated with each of curable silicone resin solutions A1 to A7 and CA1 to CA3, and the coated wafer was heated in an oven at 100°C for 2 minutes in air, to form a temporary adhesive layer on the bump-forming surface of the wafer with each film thickness shown in Table 1 below. With a glass wafer having a diameter of 200 mm (thickness: 500 μm) as a support, the silicon wafer coated with the temporary adhesive layer and the glass wafer were vacuum bonded to each other at 100°C for 2 minutes at $10^{-3}$ mbar or less under a load of 5 kN, using a wafer bonder EVG520IS manufactured by EVG Corporation so that the temporary adhesive layer and the glass wafer were aligned, then to carry out a curing process followed by fabrication of wafer laminate. The curing conditions herein included heat treatment for one hour in an oven at 180°C for the thermosetting silicone resin solution used, and light irradiation at 23°C with an illuminance of 100 mW/$cm^2$ for 120 seconds using a surface irradiation-type UV-LED (wavelength 365 nm) irradiator for the photocurable silicone resin solution used.

[Comparative Examples 4 and 5]

A surface of a 200 mm-diameter glass wafer support (thickness: 500 μm) was coated with each of curable silicone resin solutions A1 and A6, and the coated glass wafer support was heated in an oven (in air) at 100°C for 2 minutes to form a temporary adhesive layer on a surface of the glass wafer support with the film thickness shown in Table 1 below. Next, a 200-mm diameter silicon wafer (thickness: 725 μm) with copper posts of 10 μm height and 40 μm diameter formed on the entire front surface, and the glass wafer having the temporary adhesive layer were vacuum bonded to each other at 100°C for 2 minutes at $10^{-3}$ mbar or less under a load of 5 kN, using a wafer bonder EVG520IS manufactured by EVG Corporation so that the temporary adhesive layer and the silicon wafer were aligned, then to carry out a curing process followed by fabrication of wafer laminate. The curing conditions herein included heat treatment for one hour in an oven at 180°C for the thermosetting silicone resin solution used, and light irradiation at 23°C with an illuminance of 100 mW/cm$^2$ for 120 seconds using a surface irradiation-type UV-LED (wavelength 365 nm) irradiator for the photocurable silicone resin solution used.

Thereafter, various tests were carried out on the wafer laminates obtained according to the following test methods. The results are also shown in Table 1.

(1) Adhesion test

In the wafer laminate, an adhesion state at a wafer interface was visually confirmed from a glass support side, and in case of confirming no abnormality such as air bubbles generated at the interface, it was evaluated and rated as favorable and indicated with "O", and when an abnormality is confirmed, it was evaluated and rated as poor and indicated with "×".

(2) Back surface grinding resistance test

Using the wafer laminate, the back surface of the silicon wafer was ground using a diamond grinding wheel on a grinder (DAG-810, manufactured by Disco Corporation). After having ground the substrate to a thickness of 30 μm, the presence or absence of abnormalities such as cracks and peeling was checked with an optical microscope (100-times magnification). No abnormalities occurred was evaluated and rated as favorable and indicated with "O", and an abnormality occurred was evaluated and rated as poor and indicated with "×".

(3) Heat resistance test in air

The wafer laminate after completion of (2) the back surface grinding resistance test, was heated in an oven (in air) at 250°C for one hour, and the presence or absence of appearance abnormalities after having been cooled to room temperature was visually observed to be checked. When no appearance abnormalities occurred, they were evaluated and rated as favorable and indicated with a "O", and when appearance abnormalities such as a void, wafer swelling, or wafer damage occurred, they were evaluated and rated as poor and indicated with "×".

(4) Heat resistance test in nitrogen

The wafer laminate after completion of (2) the back surface grinding resistance test was heated in an oven in nitrogen at 250°C for one hour, and the presence or absence of appearance abnormalities after having been cooled to room temperature was visually observed to be checked. When no appearance abnormality occurred, it was evaluated and rated as favorable and indicated with a "O", and when an appearance abnormality such as a void, wafer swelling, or wafer damage occurred, it was evaluated and rated as poor and indicated with "×".

(5) Peelability test after heat resistance test in air

The peelability of a substrate was evaluated by, first, attaching a dicing tape (ELP UB-3083D, manufactured by Nitto Denko Corporation) to the wafer side of the wafer laminate after completion of (3) the heat resistance test in air described above, using a dicing frame, and setting this dicing tape surface on an adsorption plate by vacuum adsorption. Thereafter, at room temperature, one point of the glass was lifted with tweezers to peel off the glass wafer. In a case in which the wafer of 30 μm thickness could be peeled off without cracking, it was indicated with "O", and when abnormalities such as cracks occurred, it was evaluated and rated as poor and indicated with "×". Upon evaluation, it was also confirmed whether the temporary adhesive layer remained as a residue on the substrate (silicon wafer) side or on the support (glass wafer) side.

(6) Peelability test after heat resistance test in nitrogen

The peelability of a substrate was evaluated in the same manner as in (5) the peelability test after heat resistance test in air described above, using the wafer laminate that had undergone (4) the heat resistance test in nitrogen described above.

(7) Cleanability and removability test

The 200-mm diameter wafer attached to a dicing frame via the dicing tape after completion of the peelability test in (5) and (6) above, was set on a spin coater with the peeled surface facing up, and sprayed for 5 minutes with a SPIS-TA-CLEANER 25 (manufactured by Shin-Etsu Chemical Co., Ltd.) as a cleaning solvent, and then rinsed by spraying isopropyl alcohol (IPA) under rotation of the wafer. Thereafter, the appearance was observed and the presence or absence of the remaining adhesive was visually checked. When no remaining resin was confirmed, it was evaluated and rated as favorable and indicated with "O", and when the remaining resin was observed, it was evaluated and rated as poor and indicated with "×".

(8) Peel strength test

A 200-mm diameter silicon wafer (thickness: 725 μm) with copper posts of 10 μm height and 40 μm diameter formed on the entire front surface, was spin-coated with each of curable silicone resin solutions A1 to A7 and CA1 to CA3, and the coated wafer was heated on a hot plate at 100°C for 2 minutes to form a silicone resin layer on the bump-forming surface of the wafer with the film thickness shown in Table 1. Thereafter, the silicone resin layer was cured under the conditions shown in Table 1, and cooled to room temperature. Then, five pieces of a polyimide tape of 150 mm long × 25 mm wide were attached on the silicone resin layer on the wafer, and the temporary adhesive layer was removed from the areas where no tape was attached. Using an AUTOGRAPH (AG-1) manufactured by Shimadzu Corporation, 120 mm of the tape was peeled off from one end at a speed of 300 mm/min at 25°C in a 180° peel manner, and the average strength applied at that time (120 mm stroke × 5 times) was taken as an initial peel strength of the silicone resin layer. Furthermore, a cured product of a silicone resin layer was fabricated on a bump-forming surface of a wafer in the same manner as above, and a tape peel strength after having been heat treated in an oven (in air) at 250°C for 1 hour was measured as a peel strength after the heat resistance test.

(9) Storage modulus measurement

A glass wafer was spin-coated with curable silicone resin solutions A1 to A7 and CA1 to CA3, respectively, and the coated wafer was heated on a hot plate at 100°C for 2 minutes to form a silicone resin layer on the glass wafer with each film thickness shown in Table 1. Thereafter, the silicone resin layer was then cured under the conditions shown in Table 1 and then cooled to room temperature. The glass wafer including the obtained silicone resin layer while being sandwiched between 25 mmΦ aluminum plates so that a load of 50 gf was applied to the silicone resin layer, was subjected to elastic modulus measurement at 25°C, using an Ares G2 manufactured by TA Instruments, and the obtained elastic modulus value was taken as the storage modulus of the silicone resin layer.

(10) Thermogravimetric measurement in air

The appropriate amount of each of curable silicone resin solutions A1 to A5 and CA1 to CA3 was poured into a mold of 100 mm (H) × 100 mm (W) × 1 mm (D) with a Teflon (R) surface coating, the excess amount of resin solution was removed with a scraper, the mold was heated on a hot plate at 100°C for 2 minutes. Thereafter, the silicone resin layer was then cured under the conditions shown in Table 1, and cooled to room temperature to fabricate a cured product of the silicone resin layer. A thermogravimetric measurement was carried out in air using 10 mg of the obtained cured product, and a 1% weight loss temperature of the cured product was measured. The apparatus used here was a TGA2 manufactured by Mettler-Toledo Pte Ltd., and the measurement conditions were 40 to 400°C (10°C/min.).

[Table 1]

| | | Example 1 | Example 2 | Example 3 | Example 4 | Example 5 | Example 6 | Example 7 | Comparative Example 1 | Comparative Example 2 | Comparative Example 3 | Comparative Example 4 | Comparative Example 5 |
|---|---|---|---|---|---|---|---|---|---|---|---|---|---|
| Substrate | | Si wafer with circuits | | | | | | | | | | | |
| Support | | Glass wafer | | | | | | | | | | | |
| Curable silicone resin solution | | A1 | A2 | A3 | A4 | A5 | A6 | A7 | CA1 | CA2 | CA3 | A1 | A6 |
| Surface for coating | | Substrate | Substrate | Substrate | Substrate | Substrate | Substrate | Substrate | Substrate | Substrate | Substrate | Support | Support |
| Temporary adhesive layer film thickness (μm) | | 60 | 55 | 62 | 61 | 63 | 61 | 57 | 57 | 58 | 61 | 59 | 60 |
| **Curing conditions** | | **180°C×1hr.** | | | | | **100mW/cm²×120sec. (23°C)** | | **180°C×1hr.** | | **100mW/cm²×120sec. (23°C)** | **180°C×1hr.** | **100mW/cm²×120sec. (23°C)** |
| Adhesiveness | | ○ | ○ | ○ | ○ | ○ | ○ | ○ | ○ | ○ | ○ | ○ | ○ |
| Back surface grinding resistance | | ○ | ○ | ○ | ○ | ○ | ○ | ○ | ○ | ×<br>Wafer breakage upon back surface grinding | ×<br>Wafer breakage upon back surface grinding | ○ | ○ |
| Heat resistance 250° C × 1 hour (in air) | | ○ | ○ | ○ | ○ | ○ | ○ | ○ | ○ | — | — | ○ | ○ |
| Peelability after heat resistance test in air | | ○ | ○ | ○ | ○ | ○ | ○ | ○ | ×<br>Wafer breakage upon peeling | — | — | ○ | ○ |
| Residue of temporary adhesive layer | | Support | Support | Support | Support | Support | Support | Support | — | — | — | Substrate | Substrate |
| Heat resistance 250° C × 1 hour (in nitrogen) | | ○ | ○ | ○ | ○ | ○ | ○ | ○ | ○ | — | — | ○ | ○ |
| Peelability in nitrogen after heat resistance test | | ○ | ○ | ○ | ○ | ○ | ○ | ○ | ○ | — | — | ○ | ○ |
| Residue of temporary adhesive layer | | Support | Support | Support | Support | Support | Support | Support | Support | — | — | Substrate | Substrate |
| Cleaning removability | Sample undergone heat resistance test in air | ○ | ○ | ○ | ○ | ○ | ○ | ○ | — | — | — | ×→○ | ×→○ |
| | Sample undergone heat resistance test in nitrogen | ○ | ○ | ○ | ○ | ○ | ○ | ○ | ○ | — | — | ×→○ | ×→○ |
| Peel strength of silicone resin layer | Substrate | Si wafer with circuits | | | | | | | | | | | |
| | Initial peel strength (gf) | 23 | 31 | 15 | 14 | 18 | 27 | 35 | 28 | Unmeasurable resulting from being uncured | Unmeasurable resulting from being uncured | — | — |
| | Peel strength after heat resistance test (gf) | 25 | 33 | 18 | 21 | 20 | 30 | 38 | 72 | Unmeasurable resulting from being uncured | Unmeasurable resulting from being uncured | — | — |
| Storage modulus of silicone resin layer | Substrate | Glass wafer | | | | | | | | | | | |
| | Peel strength after heat resistance test (gf) | 0.3 | 0.1 | 0.4 | 0.5 | 0.4 | 0.5 | 0.2 | 0.3 | 0.01 | 0.01 | — | — |
| 1% weight loss temperature (° C in air) | | 340 | 340 | 350 | 330 | 360 | 330 | 330 | 310 | Unmeasurable resulting from being uncured | Unmeasurable resulting from being uncured | — | — |

As shown in Table 1, it was confirmed that the temporary adhesive composed of the curable silicone resin composition containing the antioxidant, which was an embodiment of the present invention, exhibited sufficient curability, and was excellent in wafer processing durability, peeling stability after heat treatment in air at an elevated temperature for a long time, and cleaning removability after peel. Moreover, the improved effect of heat resistant stability was also confirmed from the results of thermogravimetric measurement in air.

In Comparative Example 1 containing no antioxidant, on the other hand, the effect described above was not observed after heat treatment at an elevated temperature for a long time in nitrogen, however, the heat treatment at an elevated temperature for a long time in air was confirmed to adversely affect the peelability in the subsequent process. In Comparative Examples 2 and 3, which used the antioxidants containing a sulfur atom or a phosphorus atom in their structure, the insufficient curing resulted, and in particular the defects in terms of wafer processability were generated.

In Comparative Examples 4 and 5, wherein a glass carrier that was the support was coated with the curable silicone resin composition to fabricate the bonded body with the silicon wafer substrate, no difference resulted between these Comparative Examples and Examples up to the peeling step, however, the temporary adhesive layer remained as the residues on the substrate upon peeling, as a result of which, in the subsequent process for evaluation of cleaning removability, the residues could not be completely washed off by employing the same step as in the present Examples. However, repeating the processes for evaluation of cleaning removability twice enabled the residues to be completely removed.

The present description includes the following embodiments.

[1]: A temporary adhesive for wafer processing for allowing a wafer to temporarily adhere to a support,

wherein the temporary adhesive for wafer processing is composed of a curable silicone resin composition that can be cured by a hydrosilylation reaction, and
the curable silicone resin composition comprises a phenolic antioxidant not comprising a phosphorus atom or a sulfur atom.

[2]: The temporary adhesive for wafer processing according to the above 1, wherein the curable silicone resin composition comprises:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) a non-functional organopolysiloxane in an amount of 0.1 to 200 parts by mass,
(D) a hydrosilylation reaction catalyst in an amount of 0.1 to 5,000 ppm in terms of metal atom amount based on a total mass of components (A), (B) and (C), and
(E) the phenolic antioxidant in an amount of 1 to 100,000 ppm based on a total mass of components (A), (B) and (C).

[3]: The temporary adhesive for wafer processing according to the above [2], wherein a mole ratio of a total of SiH groups in component (B) to a total of alkenyl groups in component (A) is from 0.3 to 5.0.
[4]: The temporary adhesive for wafer processing according to any of the above [1] to [3], wherein the curable silicone resin composition is curable by light and/or heat.
[5]: The temporary adhesive for wafer processing according to any of the above [2] to [4], wherein the phenolic antioxidant as the component (E) is a hindered phenolic antioxidant.
[6]: The temporary adhesive for wafer processing according to any of the above [1] to [5], wherein the non-functional organopolysiloxane as the component (C) is dimethylpolysiloxane, and a 30% by mass toluene solution of the component (C) has a viscosity at 25°C of 100 to 500,000 mPa·s.
[7]: The temporary adhesive for wafer processing according to any of the above [1] to [6], wherein the curable silicone resin composition comprising the phenolic antioxidant further comprises, as component (F), a hydrosilylation reaction control agent in an amount of 0.001 to 10 parts by mass based on a total mass of the components (A), (B), and (C).
[8]: The temporary adhesive for wafer processing according to any of the above [1] to [7], wherein the curable silicone resin composition comprising the phenolic antioxidant has a 180° peel strength at 25°C after curing of 2 gf or more and 100 gf or less when a test specimen with a width of 25 mm is peeled from a silicon substrate.
[9]: The temporary adhesive for wafer processing according to any of the above [1] to [8], wherein the curable silicone resin composition comprising the phenolic antioxidant has a storage modulus at 25°C after curing of 1,000 Pa or more and 1,000 MPa or less.
[10]: The temporary adhesive for wafer processing according to any of the above [1] to [9], wherein the wafer is coated

with the curable silicone resin composition comprising the phenolic antioxidant to fabricate a laminate, allowing a peel interface when peeled off to be controlled so that the peel interface is an interface between a temporary adhesive layer obtained from the temporary adhesive for wafer processing and the wafer.

[11]: The temporary adhesive for wafer processing according to any of the above [1] to [10], wherein the support is coated with the curable silicone resin composition comprising the phenolic antioxidant to fabricate a laminate, allowing a peel interface when peeled off to be controlled so that the peel interface is an interface between a temporary adhesive layer obtained from the temporary adhesive for wafer processing and the support.

[12]: A method for producing a thin wafer, comprising the steps of:

(a) allowing a circuit-forming surface of a wafer having the circuit-forming surface on a front surface and a circuit-free surface on a back surface to peelably adhere to a support using the temporary adhesive for wafer processing according to any of the above [1] to [11] to form a wafer laminate;
(b) curing the temporary adhesive;
(c) grinding or polishing the circuit-free surface of the wafer in the wafer laminate;
(d) subjecting the circuit-free surface of the wafer to processing; and
(e) peeling off the wafer subjected to the processing from the support.

[13]: A wafer laminate comprising: a support; a temporary adhesive layer obtained from the temporary adhesive for wafer processing according to any of the above [1] to [11] stacked on the support; and a wafer having a circuit-forming surface on a front surface and a circuit-free surface on a back surface, wherein the temporary adhesive layer is peelably adhered to the surface of the wafer.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

**1.** A temporary adhesive for wafer processing for allowing a wafer to temporarily adhere to a support,

wherein the temporary adhesive for wafer processing is composed of a curable silicone resin composition that can be cured by a hydrosilylation reaction, and
the curable silicone resin composition comprises a phenolic antioxidant not comprising a phosphorus atom or a sulfur atom.

**2.** The temporary adhesive for wafer processing according to claim 1, wherein the curable silicone resin composition comprises:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) a non-functional organopolysiloxane in an amount of 0.1 to 200 parts by mass,
(D) a hydrosilylation reaction catalyst in an amount of 0.1 to 5,000 ppm in terms of metal atom amount based on a total mass of components (A), (B) and (C), and
(E) the phenolic antioxidant in an amount of 1 to 100,000 ppm based on a total mass of components (A), (B) and (C).

**3.** The temporary adhesive for wafer processing according to claim 2, wherein a mole ratio of a total of SiH groups in component (B) to a total of alkenyl groups in component (A) is from 0.3 to 5.0.

**4.** The temporary adhesive for wafer processing according to claim 1, wherein the curable silicone resin composition is curable by light and/or heat.

**5.** The temporary adhesive for wafer processing according to claim 2, wherein the phenolic antioxidant as the component (E) is a hindered phenolic antioxidant.

**6.** The temporary adhesive for wafer processing according to claim 2, wherein the non-functional organopolysiloxane as the component (C) is dimethylpolysiloxane, and a 30% by mass toluene solution of the component (C) has a viscosity at 25°C of 100 to 500,000 mPa·s.

**7.** The temporary adhesive for wafer processing according to claim 2, wherein the curable silicone resin composition comprising the phenolic antioxidant further comprises, as component (F), a hydrosilylation reaction control agent in an amount of 0.001 to 10 parts by mass based on a total mass of the components (A), (B), and (C).

**8.** The temporary adhesive for wafer processing according to claim 1, wherein the curable silicone resin composition comprising the phenolic antioxidant has a 180° peel strength at 25°C after curing of 2 gf or more and 100 gf or less when a test specimen with a width of 25 mm is peeled from a silicon substrate.

**9.** The temporary adhesive for wafer processing according to claim 1, wherein the curable silicone resin composition comprising the phenolic antioxidant has a storage modulus at 25°C after curing of 1,000 Pa or more and 1,000 MPa or less.

**10.** The temporary adhesive for wafer processing according to claim 1, wherein the wafer is coated with the curable silicone resin composition comprising the phenolic antioxidant to fabricate a laminate, allowing a peel interface when peeled off to be controlled so that the peel interface is an interface between a temporary adhesive layer obtained from the temporary adhesive for wafer processing and the wafer.

**11.** The temporary adhesive for wafer processing according to claim 1, wherein the support is coated with the curable silicone resin composition comprising the phenolic antioxidant to fabricate a laminate, allowing a peel interface when peeled off to be controlled so that the peel interface is an interface between a temporary adhesive layer obtained from the temporary adhesive for wafer processing and the support.

**12.** A method for producing a thin wafer, comprising the steps of:

(a) allowing a circuit-forming surface of a wafer having the circuit-forming surface on a front surface and a circuit-free surface on a back surface to peelably adhere to a support using the temporary adhesive for wafer processing according to any one of claims 1 to claim 11 to form a wafer laminate;
(b) curing the temporary adhesive;
(c) grinding or polishing the circuit-free surface of the wafer in the wafer laminate;
(d) subjecting the circuit-free surface of the wafer to processing; and
(e) peeling off the wafer subjected to the processing from the support.

**13.** A wafer laminate comprising: a support; a temporary adhesive layer obtained from the temporary adhesive for wafer processing according to any one of claims 1 to 11 stacked on the support; and a wafer having a circuit-forming surface on a front surface and a circuit-free surface on a back surface, wherein the temporary adhesive layer is peelably adhered to the surface of the wafer.

**INTERNATIONAL SEARCH REPORT**

International application No. **PCT/JP2024/009178**

**A. CLASSIFICATION OF SUBJECT MATTER**

***C09J 183/04***(2006.01)i; ***C09J 11/06***(2006.01)i; ***H01L 21/304***(2006.01)i
FI: C09J183/04; C09J11/06; H01L21/304 622J

According to International Patent Classification (IPC) or to both national classification and IPC

**B. FIELDS SEARCHED**

Minimum documentation searched (classification system followed by classification symbols)

C09J183/04; C09J11/06; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2021/112070 A1 (SHIN-ETSU CHEMICAL CO., LTD.) 10 June 2021 (2021-06-10) claims, paragraphs [0011]-[0051], [0053]-[0054], examples 1-7 | 1-13 |
| Y | WO 2021/220929 A1 (SHIN-ETSU CHEMICAL CO., LTD.) 04 November 2021 (2021-11-04) claims, paragraphs [0012]-[0052], [0054]-[0055], examples 1-13 | 1-13 |
| Y | JP 2003-96429 A (SHIN-ETSU CHEMICAL CO., LTD.) 03 April 2003 (2003-04-03) claims, paragraphs [0005]-[0006], [0009]-[0010], [0013]-[0018], examples 1-3, 5 | 1-13 |
| Y | JP 2006-213810 A (SHIN-ETSU CHEMICAL CO., LTD.) 17 August 2006 (2006-08-17) claims, paragraphs [0047]-[0051], example 6 | 1-13 |
| Y | JP 2005-298550 A (SHIN-ETSU CHEMICAL CO., LTD.) 27 October 2005 (2005-10-27) claims, paragraphs [0038]-[0042], example 7 | 1-13 |
| A | JP 2013-82801 A (SHIN-ETSU CHEMICAL CO., LTD.) 09 May 2013 (2013-05-09) entire text | 1-13 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 April 2024** | **23 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No.
PCT/JP2024/009178

C. DOCUMENTS CONSIDERED TO BE RELEVANT

| Category* | Citation of document, with indication, where appropriate, of the relevant passages | Relevant to claim No. |
|---|---|---|
| A | JP 2019-186470 A (SHIN-ETSU CHEMICAL CO., LTD.) 24 October 2019 (2019-10-24) entire text | 1-13 |

Form PCT/ISA/210 (second sheet) (July 2022)

**INTERNATIONAL SEARCH REPORT**
**Information on patent family members**

International application No.
**PCT/JP2024/009178**

| Patent document cited in search report | Publication date (day/month/year) | Patent family member(s) | Publication date (day/month/year) |
|---|---|---|---|
| WO 2021/112070 A1 | 10 June 2021 | US 2023/0002647 A1<br>claims, paragraphs [0023]-[0067], [0070]-[0071], examples 1-7<br>EP 4071223 A1<br>KR 10-2022-0108799 A<br>CN 114868232 A<br>TW 202134386 A | |
| WO 2021/220929 A1 | 04 November 2021 | US 2023/0088354 A1<br>claims, paragraphs [0028]-[0073], [0076]-[0077], examples 1-13<br>EP 4144808 A1<br>CN 115485814 A<br>KR 10-2023-0005219 A<br>TW 202204517 A | |
| JP 2003-96429 A | 03 April 2003 | US 2003/0091837 A1<br>claims, paragraphs [0005]-[0006], [0008]-[0010], [0022]-[0025], examples 1-3, 5<br>EP 1295927 A1 | |
| JP 2006-213810 A | 17 August 2006 | US 2006/0172140 A1<br>claims, paragraphs [0059]-[0062], example 6<br>KR 10-2006-0089147 A<br>TW 200632061 A | |
| JP 2005-298550 A | 27 October 2005 | (Family: none) | |
| JP 2013-82801 A | 09 May 2013 | US 2013/0089967 A1<br>entire text<br>EP 2578656 A1<br>KR 10-2013-0038157 A<br>TW 201331322 A | |
| JP 2019-186470 A | 24 October 2019 | US 2019/0318952 A1<br>entire text<br>EP 3557612 A1<br>CN 110391167 A<br>KR 10-2019-0120706 A<br>TW 202006088 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004064040 A
- JP 2006328104 A
- US 7541264 B2
- WO 2021112070 A1
- WO 2021220929 A1